Europäisches Patentamt

European Patent Office

Office européen des brevets

(11) Publication number: **0 061 202**
**B1**

(12) **EUROPEAN PATENT SPECIFICATION**

(45) Date of publication of patent specification: **03.07.85**

(21) Application number: **82102732.3**

(22) Date of filing: **24.01.80**

(60) Publication number of the earlier application in accordance with Art. 76 EPC: **0 014 388**

(51) Int. Cl.⁴: **G 11 C 11/34,** H 01 L 29/78, H 01 L 27/10

(54) Semiconductor memory device.

(30) Priority: **28.02.79 JP 22695/79**

(43) Date of publication of application: **29.09.82 Bulletin 82/39**

(45) Publication of the grant of the patent: **03.07.85 Bulletin 85/27**

(84) Designated Contracting States: **DE FR GB IT NL**

(56) References cited:
FR-A-2 358 026
FR-A-2 381 373
FR-A-2 394 143

IEEE JOURNAL OF SOLID STATE CIRCUITS, vol. SC-12, no. 4, August 1977, pages 344-349, New York (USA);A.F. DINGWALL et al; "C2L: A new high-speed high- density bulk CMOS technology".

(73) Proprietor: **NEC CORPORATION**
**33-1, Shiba 5-chome, Minato-ku**
**Tokyo 108 (JP)**

(72) Inventor: **Hamano, Kuniyuki**
**c/o Nippon Electric Co., Ltd. 33-1, Shiba-Gochome**
**Minato-ku Tokyo (JP)**
Inventor: **Ohta, Toshiyuki**
**c/o Nippon Electric Co., Ltd. 33-1, Shiba-Gochome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

## Description

The present invention relates to a semi-conductor memory device that can be realized in the form of an integrated circuit. More particularly, the invention relates to a semi-conductor memory device comprising a semiconductor substrate of one conductivity type, first and second regions of the opposite conductivity type provided in said semiconductor substrate, a channel region located between said first and second regions, a control electrode provided on said channel region via an insulating film, means for applying potentials to said control electrode and said first and second regions in such a manner that a depletion layer is formed in said substrate in the neighbourhood of said channel region, and control means for varying said potentials in such a manner as to operatively expand or shrink said depletion layer so as to provoke the accumulation of majority carriers from said substrate into said channel region, the level of accumulation of said majority carriers in said channel region being made to correspond to the stored information.

A semiconductor memory device of this type has been known from FR—A—2 394 143. In this memory device, the depletion layer extends below the channel region, and by varying the voltage between the substrate and the control electrode overlying the channel region the depletion layer can be made to expand or shrink. Thus the depth of the depletion layer may be varied beneath the channel region, and majority carriers may be injected through said depletion layer into said channel region.

In this case, the movement of the majority carriers is determined by the rather low conductivity of the depletion layer and by the potential gradient between the substrate and the channel region, and for controlling the accumulation of the majority carriers the potential of the control electrode must be controlled through three different values. Therefore, with this prior art memory device, the speed of movement of the majority carriers is restricted, and the control of the writing operations, by controlling the accumulation or withdrawal of the majority carriers, is complicated.

It is an object of the invention to provide a semiconductor memory device of the aforementioned kind whereby a high flow of majority carriers can be controlled at high speed, and where the control of the writing operations is simplified.

According to the invention, a semiconductor memory device of the aforementioned kind is characterized in that said depletion layer is formed as two depletion zones extending from said first and second regions, respectively, towards each other, and that said control means controls the shrinking of the depletion zones in such a manner that the depletion zones are separated from each other thereby to provide a carrier path between said channel region and said substrate, through which carrier path said accumulation of the majority carriers or alternatively an expulsion of majority carriers from said channel region into the substrate is performed, the existence or non-existance of accumulation of majority carriers in said channel region representing the stored information.

In this semiconductor device, the carrier path provided by operatively separating the two depletion zones from each other, offers a high conductivity, and therefore a large amount of the majority carriers can be transferred between the channel region and the substrate at high speed. In addition, the semiconductor memory device offers the advantage that the separation of the depletion layers, and therefore the forming of the carrier path, can be controlled only by controlling the voltage between the substrate and at least one of the first and second regions. It is not necessary to vary the voltage between the substrate and the control electrode overlying the channel region.

Further preferred features of the semiconductor memory device according to the invention are indicated in the sub-claims. Ring-shape pattern of semiconductor regions are known per se, for example from IEEE Journal of Solid State Circuits, Vol. SC-12, No. 4, August 1977, pages 344—348, and the use of polysilicon control electrodes is not novel per se in the art of MOS devices.

A preferred use of the present invention is in combination with punch-through readout of the information contained in the memory cell. This is claimed in the parent case 80 10 0359.1, granted as European patent 0 014 388, and does not form the subject matter of the present application.

Preferred embodiments of the present invention are now described with reference to the accompanying drawings, wherein:

Figure 1 is a cross-section view showing a memory cell according to a preferred embodiment of the present invention.

Figure 2 is a schematic circuit diagram showing a memory circuit composed of the memory cells illustrated in figure 1.

Figure 3 is a cross-sectional view showing a modification of the memory cell in figure 1.

Figure 4(A) to 4(F) are schematic cross-sectional views to be used for explaining the operation of the memory cell in figure 3.

Figure 5 is a plan view showing one example of the semiconductor integrated circuit memory devices which realizes the memory circuit of figure 2 and

Figure 6(A) to 6(D) are cross-sectional views of the integrated circuit memory device of figure 5 taken in the positions and directions indicated by arrows a to d in figure 5.

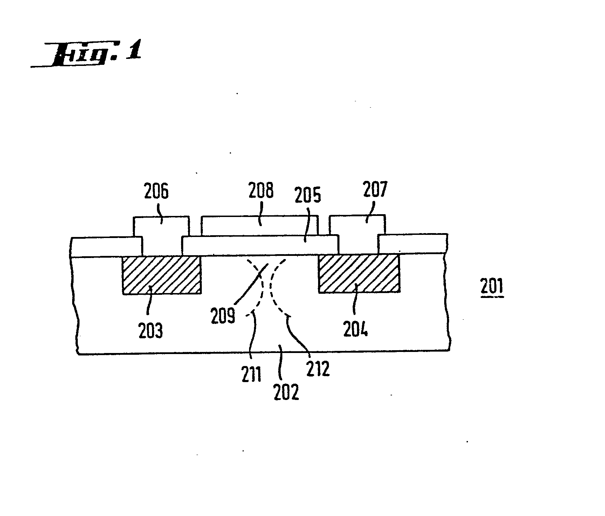

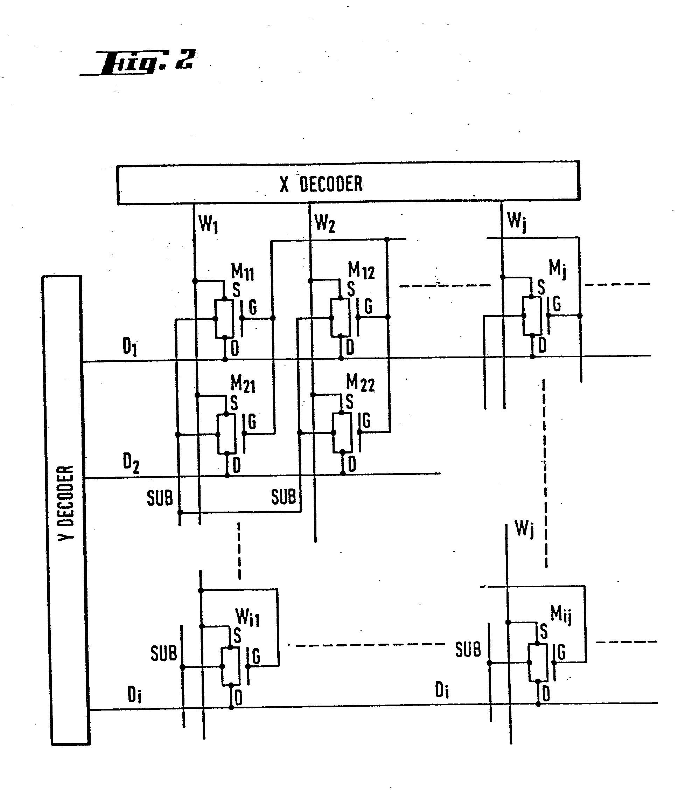

Now one preferred embodiment of the present invention will be described with reference to figure 1.

Referring to Figure 1, MOS memory cell 201 has a MOS transistor structure comprising a P-type silicon substrate 202, an N-type source 203, an N-type drain 204, a gate insulating film 205, a gate 208, and metal wirings 206 and 207. The substrate 202 contains a P-type impurity at a concentration of $3 \times 10^{14}/cm^3$. The source region 203 and drain region 204 are formed by diffusion or ion implantation of phosphorus, and they have an impurity concentration of $10^{21}/cm^3$ and a junction depth of 2.0 μ. The channel length of the channel region 209 between the source region 203 and the drain region 204 is equal to 3.0 μ, and the gate insulating film is formed of a $S_iO_2$ film of 1000 Å in thickness. While the gate 208 as well as the metal wirings 206 and 207 are made of aluminum, they could be made of any arbitrary wiring material. The depletion layers 211 and 212 formed by the source region 203 and the drain region 204, respectively, are made to have a width of 1.7 μ by the built-in potential due to the PN-junctions per se when the respective regions are held at the ground level, and they can isolate the channel region 209 from the substrate 202. In this memory cell 201, when a backward voltage is applied between the source 203 and drain 204 and the substrate 202 or when they are held at an equal potential, that is a forward voltage is not applied between them, the depletion layers 211 and 212 are extended from the source 203 and drain 204 so that they can be connected at a position under the insulating film 205. Accordingly, the state of the majority carriers in the channel region 209 can be retained. Reading of the stored information can be effected by further extending the depletion layer 212 from the drain 204 until it reaches the source 203 and detecting either existence or non-existence of the punch-through current which corresponds respectively to non-existence or existence of majority carriers in the channel region.

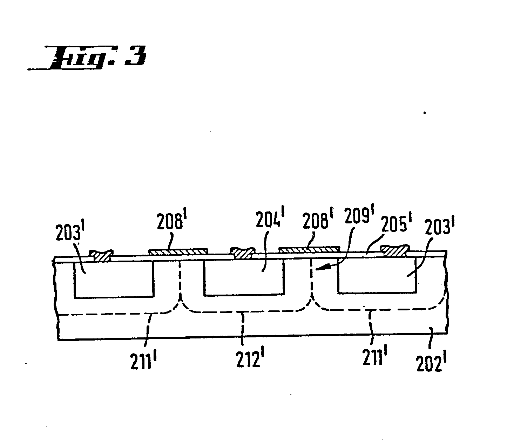

Figure 2 shows MOS memory device including a memory cell in Figure 1. In this diagram, gate electrodes (208) and substrate electrodes, respectively, of all the memory cells are respectively connected in common. Digit lines $D_1$, $D_2$, . . . . are respectively connected to the drain electrodes of the MOS transistors $M_{11}$, $M_{12}$, . . . ., $M_{21}$, $M_{22}$, . . . ., . . . . in the corresponding rows, while word lines $W_1$, $W_2$, . . . . are respectively connected to the source electrodes of the MOS transistors $M_{11}$, $M_{22}$, . . . ., . . . . in the corresponding columns.

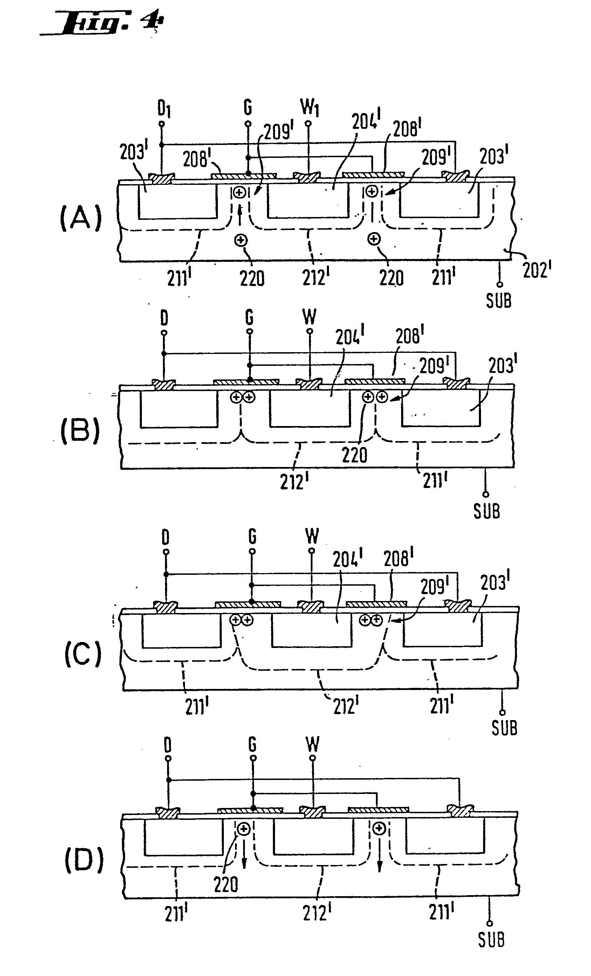

In Figure 3 is illustrated one modification of the memory cell 201 shown in Figure 2. In this modification a source region 203' is formed in a ring shape. A drain region 204' is formed in a circular shape nearly at the center of the region of the substrate 202' surrounded by the source region 203'. On a channel region 209' between the source region 203' and the drain region 204' is formed a ring-shaped gate electrode 208' via a gate insulating film 205'. In this modified construction, the impurity concentrations in the substrate 202', source region 203' and drain regions 204' are approximately equal to those in the memory cell 201 in Figure 1. Also the thickness of the gate insulating film is 1000 Å, and the channel length is 3.0 μ. In this modification, since the majority carriers are preserved while being enclosed in the ring-shaped channel region, the state of the majority carriers can be stably retained for a long period.

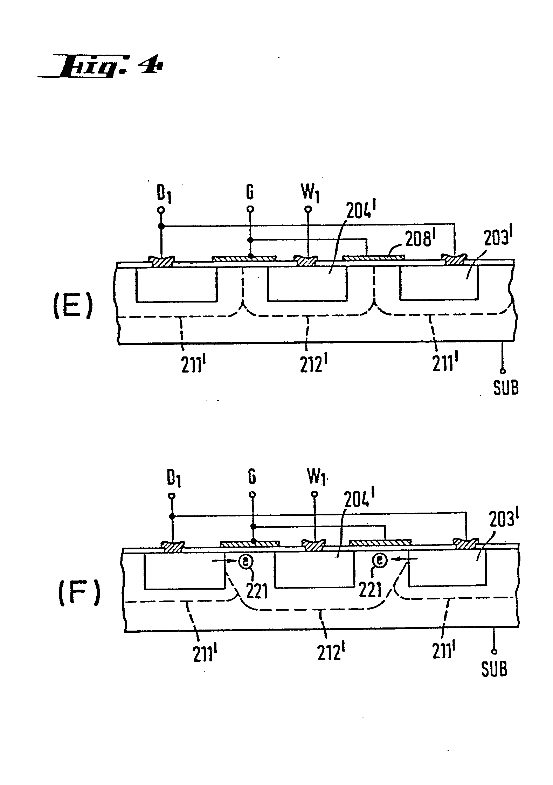

Now the operation of the memory cell shown in Figure 3 will be described with reference to Figure 4, in connection to the case where the memory cell is applied to the memory device in Figure 2 as one memory cell $M_{11}$.

At first description will be made on write-hole-read of the information "0". It is to be noted that in the following operation the substrate terminal SUB is always grounded.

Upon writing the information "0" in the memory cell $M_{11}$, the digit line $D_1$, the word line $W_1$ and the gate electrode terminal G are respectively brought to −3V. At this moment, as shown in Figure 4(A), the depletion layer 211' extending from the source 203' and the depletion layer 212' extending from the drain 204' shrink, so that the isolation between the channel region 209' and the substrate 202' is removed. Then, by the effect of the negative potential at the gate 208', positive holes 220 in the substrate 202' are accumulated in the channel region 209' as shown by arrows. In this way, writing of the information "0" is achieved. During this write operation, in the remaining memory cells other than the memory cell $M_{11}$, since both the word line and digit line are held at the ground potential or either one of the word line and digit line is held at −3V, the overlap between the two depletion layers 211' and 212' cannot be released. Therefore, the state of the majority carriers in the channel region 209' can be retained, that is, the stored information can be preserved.

Subsequently, when the written information "0" is to be held, at first the word line $W_1$ and the digit line $D_1$ are returned to the ground level to again isolate the channel region 209' from the substrate 202' by means of the depletion layers 211' and 212', and thereafter the gate electrode terminal G is returned to the ground level. Thus the accumulated positive holes 220 can be preserved in the channel region 209' as shown in Figure 4(B).

When the information "0" stored in the memory cell $M_{11}$ is to be read, the word line $W_1$ is brought to +3V, while maintaining the gate electrode terminal G at the ground level (or at a positive potential). Then the digit line $D_1$ is held at the ground level. At this moment, as shown in Figure 4(C), the depletion layer 212' extending from the drain 204' expands towards the source region 203'. However, since the positive holes are accumulated in the channel region 209' in this case, a punch-through current would not occur, or even if it occurs, the magnitude of the current is very small. This state is detected through the digit line $D_1$ and interpreted that the information "0" has been stored in the memory cell $M_{11}$. Thus reading of the information "0" can be achieved.

Now description will be made on write-hold-read of the information "1". In this case also the substrate terminal is always held at the ground level.

In this case, in response to the information "1" to be stored, the gate electrode terminal G is brought to +3V which depletes the majority carrier in the channel region 209' while the digit line $D_1$ and the word line $W_1$ are respectively brought to −3V similarly to the case of writing the information "1". At this moment, similarly to the case shown in Figure 4(A), the depletion layers 211' and 212' shrink, so that the channel region 209' is coupled to the substrate 202'. However, at this time since the gate potential is a positive potential, the positive holes 220 in the channel region 209' are pushed back to the substrate 202' as shown in Figure 4(D). Thus the channel region becomes a depletion state of positive holes, and thus writing of the information "1" is effected. During the above-mentioned write operation to the memory cell $M_{11}$, the other memory cells have only one of the source and the drain brought to −3V or have both the source and the drain held at the ground level. In the former case, one of the depletion layers extending from the source and drain, shrinks. However, with the degeneration of only one depletion layer, the contact between the depletion layers 211' and 212' is still maintained, and hence the channel region 209' cannot be coupled to the substrate 202'. In the memory cell having both the source and the drain held at the ground level, of course, the channel region 209' is kept isolated from the substrate 202'. Therefore, when the information "1" is written in one particular memory cell $M_{11}$, the information stored in the other memory cells can be preserved.

Subsequently, the digit line $D_1$ and the word line $W_1$ are returned to the ground potential to bring the depletion layers 211' and 212' into contact for isolating the channel region 209' from the substrate 202', thereafter the gate electrode terminal G is returned to the ground level. Thus a holding state of the memory cell $M_{11}$ can be established as shown in Figure 4(E).

When the information "1" stored in the memory cell $M_{11}$ is to be read out, the word line $W_1$ is brought to +3V while maintaining the gate electrode terminal G and the digit line $D_1$ at the ground level. At this moment, as shown in Figure 4(F), the depletion layer 212' extending from the drain 204' expands till the source region 203'. Consequently, by injection of electrons 221 from the source 203' to the channel region 209', a punch-through current is produced between the drain 204' and source 203', and hence, reading of the stored information "1" can be achieved by detecting this punch-through current via the digit line $D_1$.

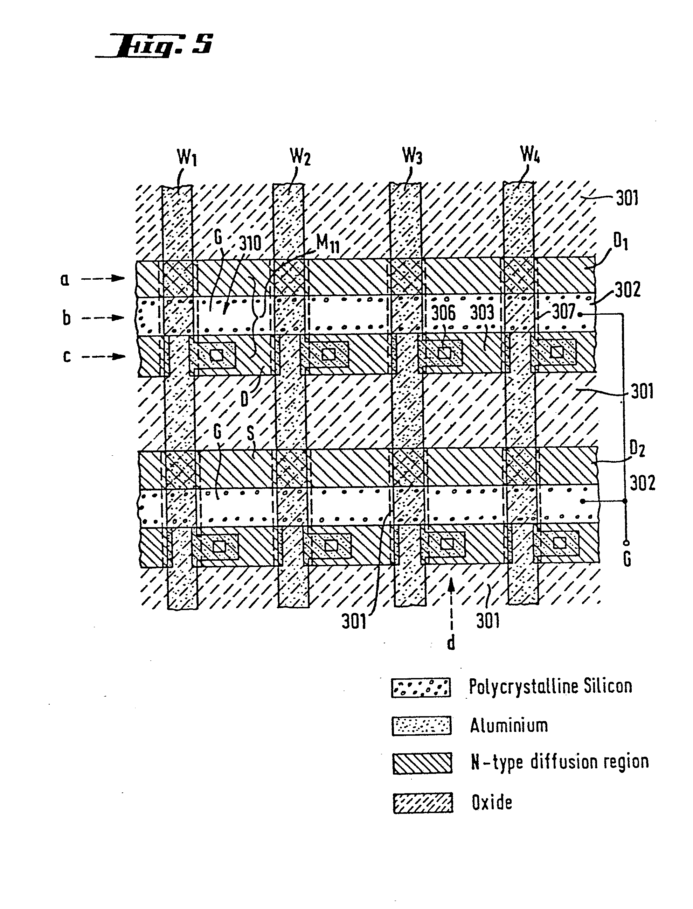

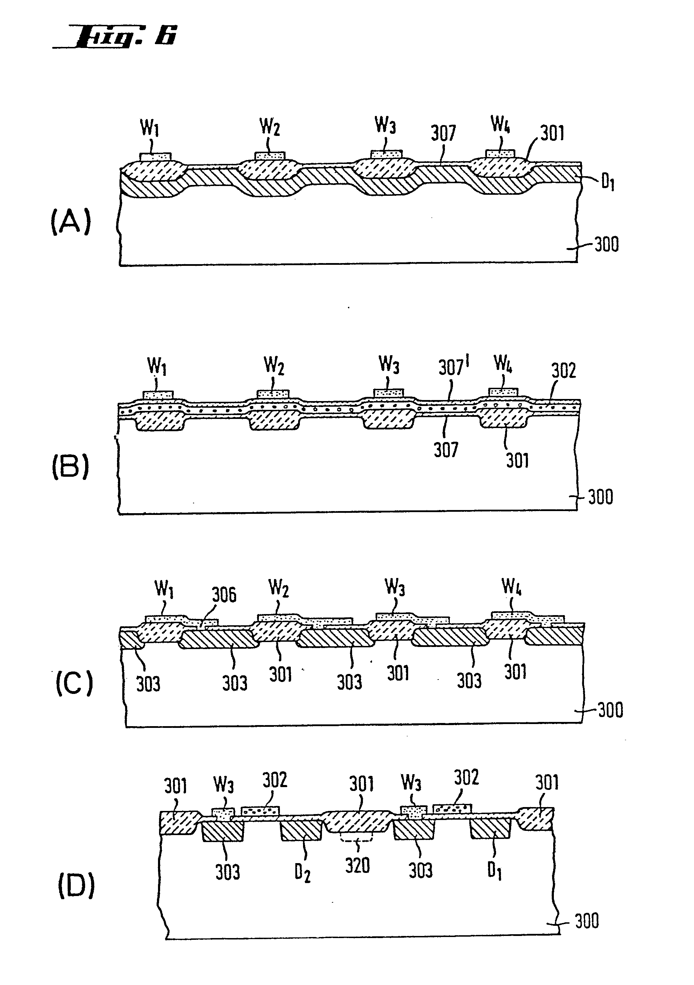

With reference to Figures 5 and 6, one example of a semiconductor integrated circuit structure of the memory circuit of Figure 2 will be described.

Digit lines $D_1$, $D_2$ are made of N-type semiconductor regions elongated in column directions provided in P-type semiconductor substrate 300. These digit lines have their depth of 2 microns as shown in Figure 6(A). Digit lines $D_1$, $D_2$ also serve as sources (S) of the memory cell such as $M_{11}$. A plurality of N-type regions 303 arranged in the column directions also serve as drains (D) of the memory cells. The N-type regions 303 have the same junction depth as those of digit lines $D_1$, $D_2$. The digit lines and N-type regions are fabricated at the same time by thermal diffusion of impurities or ion-implantation technique. A plurality of thick oxide regions 301 elongated in row and column directions and partially embedded in the surface portion of the substrate 300 are formed by selectively oxidizing the surface of the substrate 300. The thick oxide regions 301 isolate the respective rows of the memory cell matrix in the row directions. The thickness of the thick oxide regions 301 are about 1.5 micron. These thick oxide regions 301 especially surround channel regions 310 with the depletion layers extending from the drain (D) and source (S) so that the channel regions, especially the surface of the channel regions can be perfectly isolated from the substrate both in vertical and lateral directions. Word lines $W_1 \sim W_4$ are made of highly conductive metal layer such as aluminum layer elongated in the row directions and disposed on the thick oxide regions 301. These word lines $W_1 \sim W_4$ are connected to the drains (D) i.e. N-type region 303, via contact holes 306 as shown in Figure 6(C). Gates are made of polycrystalline silicon wiring layers 302 elongated in the column directions in parallel with the digit lines, as shown in Figure 6(B). The polycrystalline silicon wiring layers have a thickness of about 0.6 micron. The surface of the polycrystalline silicon wiring layers are thermally converted into its oxide to provide an insulator layer 307' for the word lines. The polycrystalline silicon wiring layers 302 are electrically connected in common. The thick oxide region 301 also isolates the column from neighbouring columns as well as the row directions as shown in Figure 6(D).

In this connection, it may be possible to provide highly doped P-type region 320, i.e. the so-called channel stopper region, under the thick oxide region 301 for further inhibiting leakage between the columns. This channel stopper region is located so as not to electrically contact with the channel regions.

While the present invention has been described above in connection to its preferred embodiments, it is a matter of course that the invention should not be limited only to the illustrated embodiments but it can be realized in various forms under various conditions of an impurity concentration and under various voltage conditions. In addition, while the channel region is isolated from the substrate by the depletion layers produced by the built-in potential in the above-described embodiments, the channel region may be isolated by producing depletion layers by an external electric field.

**Claims**

1. A semiconductor memory device comprising a semiconductor substrate (202) of one conductivity type, first and second regions (203, 204) of the opposite conductivity type provided in said semiconductor substrate, a channel region (209) located between said first and second regions, a control electrode (208) provided on said channel region via an insulating film (205), means for applying potentials to said control electrode (208) and said first and second regions (203, 204) in such a manner that a depletion layer is formed in said substrate (202) in the neighbourhood of said channel region (209), and control means for varying said potentials in such a manner as to operatively expand or shrink said depletion layer so as to provoke the accumulation of majority carriers from said substrate into said channel region, the level of accumulation of said majority carriers in said channel region being made to correspond to the stored information, characterized in that said depletion layer is formed as two depletion zones (211, 212) extending from said first and second regions (203, 204), respectively, towards each other, and that said control means controls the shrinking of the depletion zones (211, 212) in such a manner that the depletion zones are separated from each other thereby to provide a carrier path between said channel region (209) and said substrate (202), through which carrier path said accumulation of the majority carriers or alternatively an expulsion of majority carriers from said channel region into the substrate is performed, existence or non-existence of accumulation of majority carriers in said channel region representing the stored information.

2. The device according to claim 1, characterized in that one (203') of said first and second regions is formed in a ring-shape pattern and the other (204') of said first and second semiconductor regions is formed in an island pattern surrounded by said ring-shape pattern.

3. The device according to claim 1, characterized in that said control electrode (208) is formed of polycrystalline silicon.

4. The device according to claim 1, characterized in that said shrinking means includes means for controlling voltage between said semiconductor substrate (202) and at least one of said first and second semiconductor regions (203, 204).

**Patentansprüche**

1. Halbleiterspeichervorrichtung mit einem Halbleitersubstrat (202) eines ersten Leitfähigkeitstyps, einer ersten und zweiten Region (203, 204) des entgegengesetzten Leitfähigkeitstyps, die auf dem Halbleitersubstrat vorgesehen sind, einer Kanalregion (209) zwischen der ersten und zweiten Region, einer Steuerelektrode (208), die auf der Kanalregion über eine Isolationsschicht (205) aufgebracht ist, einer Vorrichtung zum Anlegen von Potentialen an die Steuerelektrode (208) und die erste und zweite Region (203, 204) in einer solchen Weise, daß eine Verarmungsschicht im Substrat (202) in der Näne der Kanalregion (209) erzeugt wird, und einer Steuervorrichtung zum Variieren der Potentiale so, daß im Betrieb die Verarmungsschicht sich ausdehnt oder schrumpft, um so eine Akkumulation von Majoritätsträgern aus dem Substrat in die Kanalregion hervorzurufen, wobei der Akkumulationspegel der Majoritätsträger im Kanalbereich so eingestellt wird, daß er der gespeicherten Information entspricht, dadurch gekennzeichnet, daß die Verarmungsschicht als zwei Verarmungszonen (211, 212) ausgeformt ist, die sich vom ersten bzw. zweiten Bereich (203, 204) aufeinanderzuerstrecken, und daß die Steuervorrichtung das Schrumpfen der Verarmungszonen (211, 212) in einer solchen Weise steuert, daß die Verarmungszonen voneinander getrennt werden, wodurch ein Ladungsträgerweg zwischen Kanalregion (209) und Substrat (202) geschaffen wird, über welchen die Akkumulation der Majoritätsträger oder alternativ ein Austreiben der Majoritätsträger von der Kanalregion in das Substrat durchgeführt wird, wobei die Existenz oder Nichtexistenz einer Akkumulation von Majoritätsträgern in der Kanalregion die gespeicherte Information repräsentiert.

2. Anordnung nach Anspruch 1, dadurch gekennzeichnet, daß eine (203') der ersten und zweiten Region als ringförmige Struktur ausgeformt ist und die andere (204') von der ersten und zweiten Halbleiterregion in Inselform, die von der Ringform umgeben wird.

3. Anordnung nach Anspruch 1, dadurch gekennzeichnet, daß die Steuerelektrode (208) aus polykristallinem Silicium besteht.

4. Anordnung nach Anspruch 1, dadurch gekennzeichnet, daß die Schrumpfvorrichtung eine Vorrichtung enthält zum Steuern der Spannung zwischen dem Halbleitersubstrat (202) und mindestens einer von der ersten und zweiten Halbleiterregion (203, 204).

**Revendications**

1. Dispositif semi-conducteur à mémoire comprenant un substrat semi-conducteur (202) d'un type de conductibilité, des première et seconde régions (203, 204) du type de conductibilité opposé prévues dans le substrat semi-conducteur, une région de canal (209) située entre les première et seconde régions, une électrode de commande (208) prévue sur la région de canal via une pellicule isolante (205), un moyen pour appliquer des potentiels à l'électrode de commande (208) et aux première et seconde régions (203, 204) d'une manière telle qu'une couche d'épuisement est formée dans le substrat (202) au voisinage de la région de canal (209), et un moyen de commande pour faire varier les potentiels d'une manière telle qu'il y a expansion ou rétrécissement fonctionnels de la couche d'épuisement dans le but de provoquer l'accumulation de porteurs majoritaires à partir du substrat dans la région de canal, le niveau d'accumulation des porteurs majoritaires dans la région de canal étant amené à correspondre à l'information stockée, caractérisé en ce que la couche d'épuisement se présente sous la forme de deux zones d'épuisement (211, 212) s'étendant à partir des première et seconde régions (203, 204), respectivement, l'une vers l'autre, et que le moyen de commande contrôle le rétrécissement des zones d'épuisement (211, 212), d'une manière telle que les zones d'épuisement sont séparées l'une de l'autre dans le but de fournir un trajet de porteurs entre la région de canal (209) et le substrat (202), trajet par lequel est effectuée l'accumulation des porteurs majoritaires ou, en variante, une expulsion des porteurs majoritaires entre la région de canal et le substrat, l'existence ou la non-existence de l'accumulation de porteurs majoritaires dans la région de canal représentant l'information stockée.

2. Dispositif selon la revendication 1, caractérisé en ce que l'une (203') des première et seconde régions est réalisée suivant un motif en forme d'anneau et l'autre (204') des première et seconde régions en semi-conducteur est réalisée en motif sous forme d'île qui est entouré par le motif en forme d'anneau.

3. Dispositif selon la revendication 1, caractérisé en ce que l'électrode de commande (208) est constituée de silicium polycristallin.

4. Dispositif selon la revendication 1, caractérisé en ce que le moyen de rétrécissement comprend un moyen pour régler la tension entre le substrat en semi-conducteur (202) et au moins l'une des première et seconde régions en semi-conducteur (203, 204).

## Fig. 1

206        208   205        207

201

203

209        204

211   212

202

# Fig. 2

_Fig. 3_

# Fig. 4

(A)

(B)

(C)

(D)

# Fig. 4

**(E)**

D₁  G  W₁  204'  208'  203'

211'  212'  211'

SUB

**(F)**

D₁  G  W₁  204'  203'

221  221

211'  212'  211'

SUB

*Fig. 5*

# Fig. 6

(A)

(B)

(C)

(D)